(19) Europäisches Patentamt
European Patent Office
Office européen des brevets

(11) **EP 2 153 497 B1**

(12) **FASCICULE DE BREVET EUROPEEN**

(45) Date de publication et mention
de la délivrance du brevet:
**06.06.2012 Bulletin 2012/23**

(21) Numéro de dépôt: **08749785.5**

(22) Date de dépôt: **28.04.2008**

(51) Int Cl.:
**H01R 13/641** *(2006.01)*    **H01R 13/24** *(2006.01)*

(86) Numéro de dépôt international:
**PCT/EP2008/055158**

(87) Numéro de publication internationale:
**WO 2008/135426 (13.11.2008 Gazette 2008/46)**

(54) **DISPOSITIF ELECTRONIQUE COMPORTANT DEUX COMPOSANTS ELECTRONIQUES RELIES ENTRE EUX PAR UN CONNECTEUR SOUPLE**

ELEKTRONISCHE ANORDNUNG MIT ZWEI DURCH EINEN FLEXIBLEN VERBINDER MITEINANDER VERBUNDENEN ELEKTRONISCHEN KOMPONENTEN

ELECTRONIC DEVICE INCLUDING TWO ELECTRONIC COMPONENTS CONNECTED TOGETHER BY A FLEXIBLE CONNECTOR

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **27.04.2007 FR 0703045**

(43) Date de publication de la demande:
**17.02.2010 Bulletin 2010/07**

(73) Titulaire: **Valeo Systèmes Thermiques
78321 Le Mesnil St Denis Cedex (FR)**

(72) Inventeur: **HUYNH, Tan Duc
F-93330 Neuilly Sur Marne (FR)**

(74) Mandataire: **Benoit, Monique et al
Valeo Management Services
43, rue Bayen
75017 Paris (FR)**

(56) Documents cités:
**EP-A- 1 052 736        EP-A- 1 322 001
WO-A- 94/07318        DE-U1- 20 210 025
US-A- 4 949 035        US-A- 6 143 989
US-A1- 2006 134 997**

## Description

## Domaine technique de l'invention.

L'invention est du domaine des dispositifs d'affichage à cristaux liquides, notamment destinés à être installés sur un élément structurel d'un véhicule automobile. Elle a pour objet un tel dispositif comportant deux composants électroniques reliés entre eux par un connecteur souple.

## Etat de la technique.

Dans le domaine automobile, il est courant d'équiper un véhicule d'un dispositif électronique comportant deux composants électroniques reliés entre eux par un connecteur souple. Un tel dispositif est par exemple un dispositif d'affichage d'informations qui est destiné à être installé sur un élément structurel du véhicule, tel qu'une planche de bord, une console ou analogue. Ce dispositif est par exemple prévu pour délivrer à un utilisateur du véhicule une information, telle qu'une information générale, du type date, heure, température extérieure au véhicule ou analogue. Ce dispositif est aussi susceptible de délivrer à l'utilisateur une information particulière relative au fonctionnement du véhicule, voire une information relative au fonctionnement d'une installation équipant ce dernier, telle qu'une installation de ventilation, de chauffage et/ou de climatisation.

Dans le cas d'exemple où le dispositif électronique est un dispositif d'affichage, un premier composant électronique est organisé en un écran d'affichage, à cristaux liquides notamment ou analogue, tandis qu'un deuxième composant est une carte de commande de la mise en oeuvre de l'écran d'affichage. La carte de commande et l'écran d'affichage sont logés dans un boîtier en étant disposés en superposition l'un de l'autre. Une source lumineuse, telle qu'une diode électroluminescente ou analogue, est placée entre l'écran d'affichage et la carte de commande pour éclairer l'écran d'affichage par rétro-éclairage.

L'écran d'affichage comporte une pluralité de pistes électriques qui comprennent des segments d'affichage intégré à l'écran. Chaque segment est réalisé en cristaux liquides, à partir d'un procédé de photolithographie par exemple, et est bordé par deux électrodes. Une tension électrique est susceptible d'être appliquée aux électrodes d'un segment pour orienter les cristaux liquides de ce dernier de sorte que la lumière émise par la source lumineuse le traverse. L'application de la tension électrique à un segment particulier est commandée par un microprocesseur que comporte la carte de commande.

Se pose donc le problème général de la mise en relation des pistes électriques de l'écran d'affichage avec le microprocesseur. Le courant électrique circulant à travers les pistes électriques de l'écran d'affichage étant de faible intensité, inférieur au milliampère notamment, il est possible de relier électriquement les pistes électriques de l'écran d'affichage et le microprocesseur par l'intermédiaire d'un connecteur souple. Ce dernier est constitué d'une pluralité de lamelles conductrices, réalisées en carbone notamment, une lamelle isolante, réalisée en un polymère électriquement isolant, tel qu'un silicone ou analogue, étant interposée entre deux lamelles conductrices successives. Une extrémité d'une lamelle conductrice est en contact avec un premier plot de connexion porté par la carte de commande, tandis que l'autre extrémité de la lamelle conductrice est en contact avec un deuxième plot de connexion constitutif de la piste électrique de l'écran d'affichage.

Pour permettre une mise en oeuvre fiable du dispositif d'affichage, il est nécessaire qu'au cours du processus d'assemblage de ce dernier, la mise en contact électrique entre d'une part les plots de connexion de l'écran d'affichage et ceux de la carte de commande et d'autre part les extrémités correspondantes des lamelles conductrices soit précise, fiable, rapide à effectuer et néanmoins pérenne. Le caractère souple du connecteur constitue un inconvénient à l'encontre de la fiabilité du dispositif, le connecteur souple tendant à se déformer lors de sa mise en place entre l'écran d'affichage et la carte de commande électronique. Cette déformation est susceptible d'entraîner une rupture de la mise en contact électrique entre les plots de connexion et les extrémités des lamelles. A l'issue du processus d'assemblage du dispositif d'affichage, le connecteur souple est difficilement accessible, de sorte qu'un repositionnement de ce dernier est long et fastidieux, pour un résultat final demeurant aléatoire et incertain. Il en découle finalement que de tels conducteurs souples tendent à être remplacés par des connecteurs rigides, qui présentent l'inconvénient d'être plus encombrant et plus onéreux, et qui nécessitent un contrôle dimensionnel accru par rapport aux connecteurs souples.

## Objet de l'invention.

Le but de la présente invention est de proposer un dispositif électronique comprenant aux moins deux composants électroniques reliés électriquement l'un à l'autre par un connecteur souple, dont la fiabilité du montage soit aisément et rapidement contrôlée, pour garantir une mise en oeuvre satisfaisante du dispositif électronique.

Le dispositif électronique de la présente invention est un dispositif destiné à être installé sur un élément structurel d'un véhicule automobile. Ce dispositif électronique comprend au moins deux composants électroniques reliés électriquement l'un à l'autre par l'intermédiaire d'un connecteur souple. Ce dernier comporte une pluralité de lamelles conductrices dont les extrémités sont maintenues en contact contre des plots respectifs de connexion que comporte chacun des composants électroniques. Un tel dispositif est décrit dans le document EP 1 322 001 A.

Selon la présente invention, le dispositif électronique est équipé d'un moyen de contrôle de l'état de compression du connecteur souple.

Ces dispositions sont telles qu'en fin du processus d'assemblage du dispositif électronique, il est possible de vérifier aisément et rapidement l'état de compression du connecteur souple.

Le moyen de contrôle comprend avantageusement un circuit électrique dédié à la détermination de l'état de compression du connecteur souple.

Le moyen de contrôle comprend avantageusement un circuit électrique intégrant au moins une lamelle conductrice supplémentaire du connecteur souple.

Il résulte de ces dispositions qu'il est possible de contrôler ponctuellement, et plus particulièrement au voisinage de la lamelle conductrice supplémentaire constitutive du circuit électrique, l'état de compression du connecteur souple.

Selon une autre caractéristique de l'invention, les extrémités des lamelles conductrices sont maintenues en contact contre des plots respectifs de connexion que comporte chacun des composants électroniques.

Le circuit électrique intègre préférentiellement deux lamelles conductrices supplémentaires du connecteur souple qui sont respectivement disposées aux bords latéraux opposés de ce dernier.

Ces dispositions sont telles que l'état de compression du connecteur souple est contrôlé sur l'ensemble de sa longueur.

Le circuit électrique comprend une résistance de référence Rf montée en série avec au moins une lamelle conductrice supplémentaire.

Le moyen de contrôle comprend en outre avantageusement des moyens de calcul de la résistance totale Rt du circuit électrique.

Le moyen de contrôle comprend de préférence des moyens de conversion de la résistance totale mesurée Rt du circuit électrique en un coefficient de compression du connecteur souple.

L'état de compression du connecteur souple est appréhendé à partir d'un calcul de la résistance totale du circuit électrique, ce dernier comprenant les zones de contact entre les plots de connexion et les extrémités des lamelles. Comme il existe une relation inversement proportionnelle entre l'état de compression du connecteur souple et la résistance desdites zones de contact, il est possible de déduire d'un calcul de la résistance totale Rt du circuit électrique une estimation du coefficient de compression du connecteur souple.

Le moyen de contrôle comprend avantageusement des moyens de comparaison du coefficient de compression calculé par rapport à une valeur de consigne.

La valeur de consigne est préférentiellement de 10%.

Il est apparu à l'usage qu'une compression de 10% du connecteur souple constitue une valeur seuil et qu'une compression du connecteur inférieure à cette valeur seuil ne garantit pas une continuité satisfaisante du circuit électrique au niveau des zones de contact. On comprendra qu'une compression de 10% du connecteur souple correspond à une diminution de 10% d'une dimension du connecteur relative à son extension entre les composants électroniques.

Selon une variante préférée de réalisation de la présente invention, un premier composant électronique est un écran d'affichage tandis qu'un deuxième composant électronique est une carte de commande de la mise en oeuvre de l'écran d'affichage.

L'écran d'affichage est par exemple un écran à cristaux liquides.

L'écran d'affichage est notamment un écran d'affichage d'une information relative au fonctionnement d'une installation de ventilation, de chauffage et/ou de climatisation.

Avantageusement, une partie du circuit électrique est porté par l'écran d'affichage.

Préférentiellement, le moyen de contrôle est logé à l'intérieur du dispositif électronique.

Ces dispositions sont telles que le dispositif électronique intègre intrinsèquement les moyens de contrôle, sans nécessité d'avoir recours à un quelconque appareil accessoire.

L'invention porte également sur un tableau de commande comprenant un dispositif électronique selon l'une des caractéristiques précédentes.

En outre, l'invention porte sur un appareil apte à coopérer avec le moyen de contrôle du dispositif électronique pour déterminer l'état de compression du connecteur souple, comprenant des moyens de calcul de la résistance totale Rt du circuit électrique, des moyens de conversion de la résistance totale mesurée Rt du circuit électrique en un coefficient de compression du connecteur souple et des moyens de comparaison du coefficient de compression calculé par rapport à une valeur de consigne.

Avantageusement, la valeur de consigne est de 10%.

**Description des figures.**

La présente invention sera mieux comprise, et des détails en relevant apparaîtront, à la lecture de la description qui va être faite de variantes de réalisation en relation avec les figures des planches annexées, dans lesquelles :

La fig.1 est une vue schématique en perspective éclatée d'un dispositif d'affichage selon la présente invention.
La fig.2 est une vue schématique d'un connecteur souple constitutif du dispositif d'affichage illustré sur la figure précédente.
Les fig.3 et fi.4 sont des vues schématiques respectives de variantes de réalisation d'un écran d'affichage constitutif du dispositif d'affichage illustré sur la fig.1.

La fig.5 est une vue schématique en coupe du dispositif d'affichage illustré sur la fig.1

La fig.6 est une illustration schématique d'un montage électrique constitutif d'un composant électronique du dispositif d'affichage illustré sur les fig.1 et fig.5.

La fig.7 représente une courbe illustrant la résistance du connecteur souple illustré sur la fig.2 en fonction de son état de compression.

La fig.8 est une illustration schématique d'un microcontrôleur constitutif du dispositif d'affichage illustré sur la fig.1.

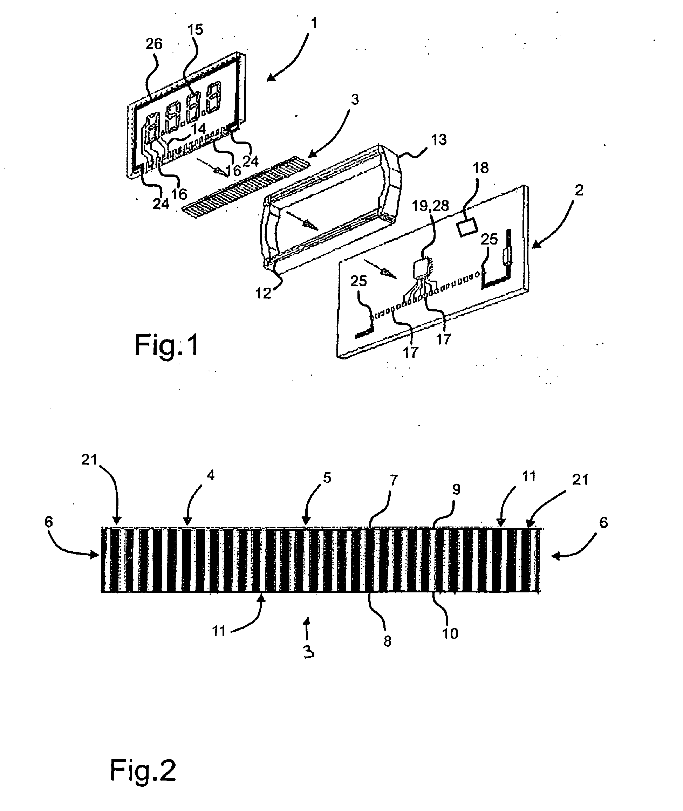

**[0034]** Sur la fig.1, un dispositif électronique est représenté. Selon ce mode de réalisation, le dispositif électronique formé par un dispositif d'affichage d'une information relative à une installation de ventilation, de chauffage et/ou de climatisation d'un véhicule automobile comprend un écran d'affichage 1 et une carte électronique de commande 2 de la mise en oeuvre de l'écran d'affichage 1. Le dispositif d'affichage est par exemple destiné à être installé sur un élément structurel du véhicule, tel qu'une planche de bord, un tableau de commande ou analogue, pour délivrer à un utilisateur l'information relative au fonctionnement de l'installation.

**[0035]** L'écran d'affichage 1 et la carte de commande 2 sont reliés électriquement l'un à l'autre par un connecteur souple 3, tel que celui illustré sur la fig.2. Un tel connecteur est connu comme connecteur élastomère feuilleté (appelé «connecteur zébra ») comportant une succession de couches élastomères non conductrices et de couches élastomères conductrices disposées alternativement, les couches ayant des bords qui définissent sur le connecteur deux surfaces de connexion opposées. On entend par « souple » le fait que le connecteur puisse être compressé sans subir de détérioration. Ce connecteur souple 3 est du type connecteur élastomère. Il est formé d'une succession alternée de lamelles électriquement conductrices 4, par exemple réalisées en carbone, et de lamelles électriquement isolantes 5, notamment réalisées en une matière plastique, telle qu'une silicone. Les lamelles conductrices 4 et isolantes 5 sont orientées parallèlement aux bords latéraux 6 du connecteur souple 3 de sorte que les extrémités 7, 8 d'une lamelle conductrice 4 et les extrémités 9, 10 d'une lamelle isolante 5 soient disposées en alternance aux bords longitudinaux 11 du connecteur souple 3.

**[0036]** Lors de l'assemblage des éléments constitutifs du dispositif d'affichage, le connecteur souple 3 est inséré dans une rainure 12 ménagée dans un boîtier 13 de conformation annulaire. Puis, ce dernier 13 est interposé entre l'écran d'affichage 1 et la carte de commande 2, de telle sorte que les bords longitudinaux 11 du connecteur souple 3 soient maintenus en contact, et finalement comprimés, respectivement contre l'écran d'affichage 1 et la carte de commande 2.

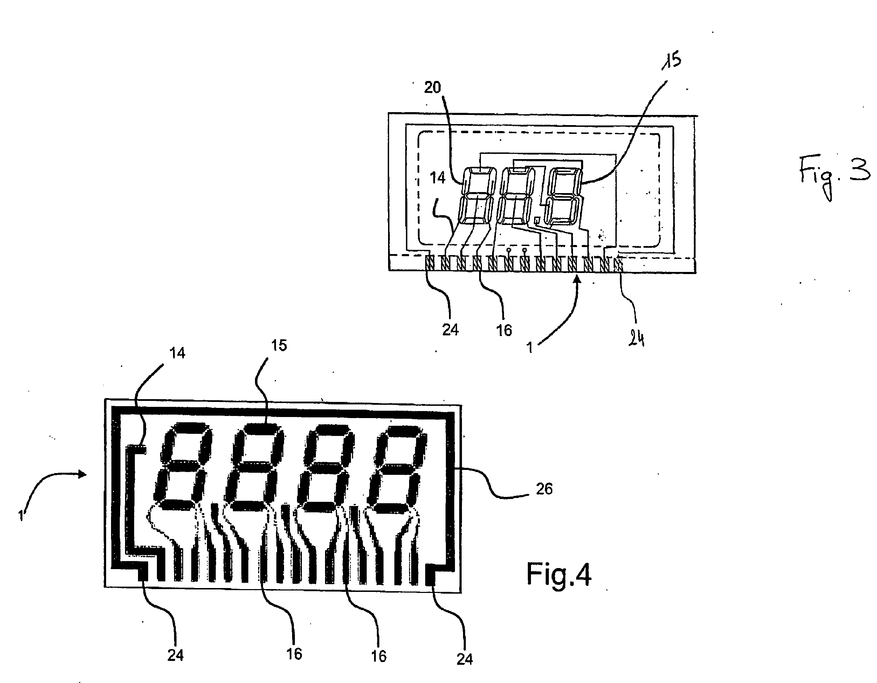

**[0037]** L'écran d'affichage 1, du type de ceux illustrés sur les fig.3 et fig.4, intègre une pluralité de pistes électriques 14 comportant au moins un segment d'affichage 15 réalisé en cristaux liquides. Chaque piste électrique 14 comprend un plot de connexion 16 ménagé en bordure périphérique de l'écran d'affichage 1. Chaque plot de connexion 16 de l'écran d'affichage 1 est en contact avec une première extrémité 7 d'une lamelle conductrice 4 du connecteur souple 3, la deuxième extrémité 8 de chaque lamelle conductrice 4 étant en contact avec un plot de connexion 17 ménagé sur la carte de commande 2. Cette dernière 2 est équipée d'une source lumineuse 18, diode électroluminescente notamment, et d'un microprocesseur 19 en relation avec l'ensemble des plots de connexion 17 de la carte de commande 2. Le microprocesseur 19 est apte à délivrer une tension à des électrodes 20 bordant chaque segment d'affichage 15 pour orienter les cristaux liquides de ce dernier 15, de telle sorte qu'ils laissent passer la lumière émise par la source lumineuse 18. Cette tension est transmise depuis le microprocesseur 19 à un segment d'affichage particulier 15 par l'intermédiaire du plot de connexion correspondant 17 de la carte de commande 2, puis de la lamelle conductrice 4 affectée à ce plot de connexion 17, puis par l'intermédiaire du plot de connexion correspondant 16 de l'écran d'affichage 1 qui est en relation avec la piste électrique 14 comportant ledit segment particulier 1 S.

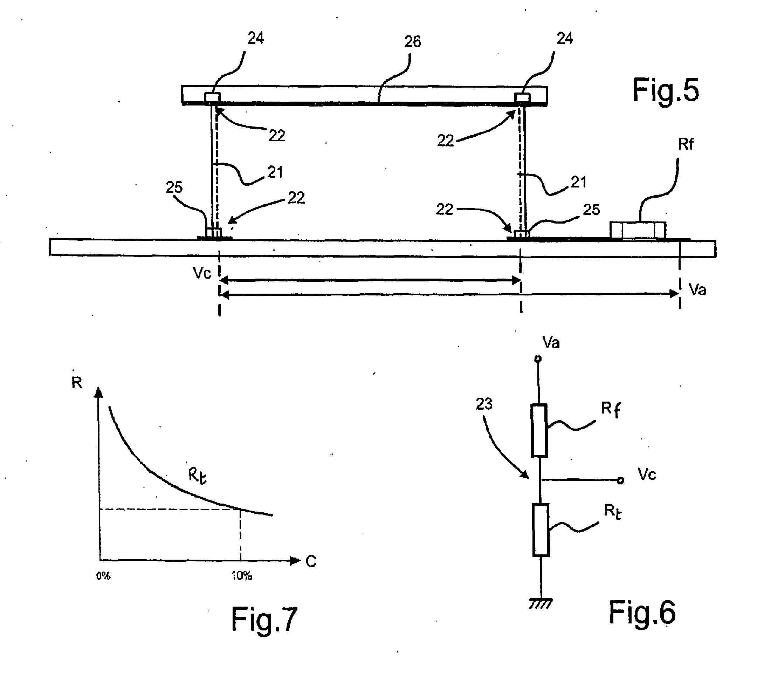

**[0038]** Sur la fig.5, le connecteur souple 3 comprend, en sus des lamelles conductrices 4, deux lamelles conductrices supplémentaires 21 qui sont ménagées à ses bords latéraux opposés 6. Ces lamelles conductrices supplémentaires 21 sont identiques aux lamelles conductrices 4 du point de vue de leur structure. Elles constituent avec les lamelles conductrices 4 un ensemble monobloc formant le connecteur souple 3. Il est ainsi avantageusement proposé par la présente invention d'adjoindre aux lamelles conductrices 4, qui sont destinées à mettre en oeuvre les segments d'affichage 15, deux lamelles conductrices supplémentaires 21, qui constituent en partie un moyen de contrôle 32 de l'état de compression du connecteur souple 3. Plus particulièrement, cette adjonction de deux lamelles conductrices supplémentaires 21 permet d'appréhender la qualité de la continuité électrique en des zones de contact 22 entre les extrémités 7, 8 des lamelles conductrices 4 et les plots correspondants de connexion 16, 17. Ces zones de contact 22 présentent des résistances électriques qui sont d'autant plus importantes que les extrémités 7, 8 des lamelles conductrices 4 et les plots de connexion 16, 17 sont comprimés les unes contre les autres de manière insatisfaisante. Il est donc avantageusement proposé par la présente invention d'exploiter une mesure de la résistance électrique totale Rt du circuit électrique, puisque la valeur de la résistance électrique Rt est fonction des résistances électriques des zones de contact 22, pour en déduire un taux de compression C du connecteur souple 3 et finalement une estimation de la qualité de la continuité électrique de ces zones de contact 22.

**[0039]** A cette fin, le moyen de contrôle 32 comprend

un circuit électrique 23 dédié à la détermination de l'état de compression du connecteur souple 3. Ainsi, les lamelles conductrices supplémentaires 21 font partie intégrante d'un circuit électrique 23, illustré sur la fig.6. En appliquant une tension de contrôle Va aux bornes de ce circuit électrique 23, il est possible de mesurer la résistance électrique totale Rt du circuit électrique 23. Du fait que la valeur de la résistance électrique totale Rt dépend de la valeur de la résistance de chaque zone de contact 22 et du fait que la résistance des zones de contact 22 d'un connecteur souple 3 varie de manière inversement proportionnelle au taux de compression C de ce connecteur souple 3, tel qu'illustré sur la fig.7, il est possible de déduire l'état de compression du connecteur souple 3. Si cet état de compression est inférieur à une valeur seuil de 10%, on considère que la mise en contact entre le connecteur souple 3, l'écran d'affichage 1 et la carte de commande 2 est insatisfaisante, voire défectueuse.

Le circuit électrique 23 comporte également des plots de connexion supplémentaires 24, 25 respectivement ménagées sur l'écran d'affichage 1 et la carte de commande 2, qui sont en contact avec les extrémités correspondantes 7, 8 des lamelles conductrices supplémentaires 21. Le circuit électrique 23 comporte encore une piste additionnelle 26 ménagée en bordure périphérique de l'écran d'affichage 1, qui relie entre eux les plots de connexion supplémentaires 24 de l'écran d'affichage 1. Ainsi, une partie du circuit électrique 23 est porté par l'écran d'affichage. Le circuit électrique 23 comporte enfin une résistance de référence Rf de valeur connue qui est portée par le composant de commande 2 en étant placée en série avec les lamelles conductrices supplémentaires 21 et la piste additionnelle 26. Cette résistance de référence Rf forme un pont de diviseur de tension pour lequel, on a la relation suivante :

$$Vc / Rt = Va / (Rf + Rt)$$

dans laquelle:

Vc est une tension mesurée aux bornes du connecteur souple 3, et t
Va est une tension connue appliquée aux bornes du circuit électrique 23.

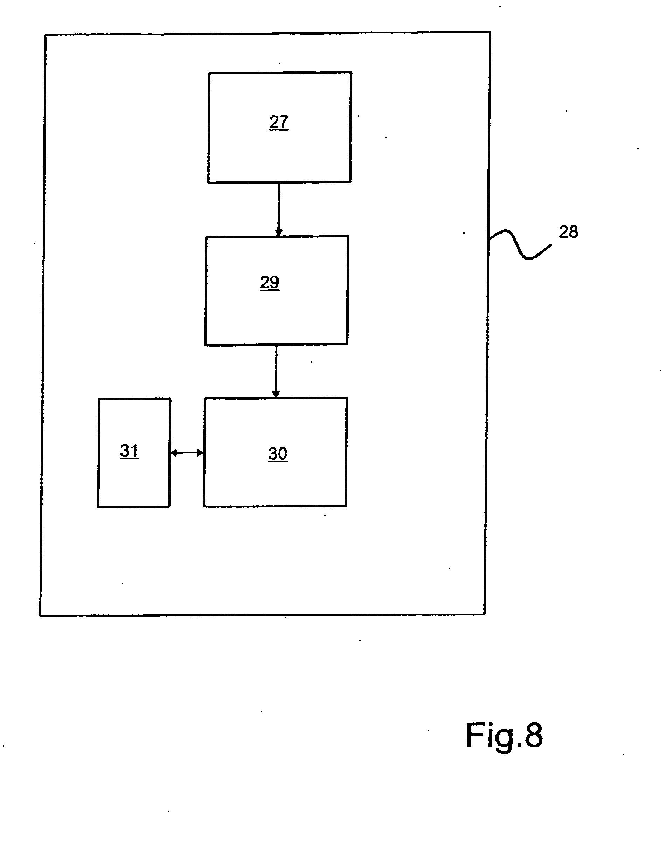

La mesure de la tension Vc permet de déduire une valeur de Rt à partir de la mise en oeuvre de moyens de calcul 27 que comporte un microcontrôleur 28, tel qu'illustré sur la fig.8. Ce dernier 28 est indifféremment un microcontrôleur externe équipant le dispositif d'affichage ou un microcontrôleur interne intégré au microprocesseur 19 porté par la carte de commande 2. Dans le cas où le microcontrôleur 28 est dit « externe », ce dernier est logé dans un appareil apte à coopérer avec le moyen de contrôle 32 du dispositif électronique. Cet appareil, une fois connecté au circuit électrique 23 permet de déterminer l'état de compression du connecteur souple 3. Ainsi, cet appareil permet, par exemple, de contrôler l'état de compression du connecteur souple 3 lorsque ce dernier est monté entre l'écran d'affichage et la carte de commande en fin de ligne de production sans nécessité d'accéder directement au connecteur souple 3. Il suffit de relier électriquement l'appareil au circuit électrique au niveau de la carte de commande pour déterminer l'état de compression du connecteur souple. Cet appareil est muni de moyens de connexion permet un raccordement électrique entre le microcontrôleur qu'il comporte et le circuit électrique 23. Dans le cas où le microcontrôleur est dit « interne », il est logé à l'intérieur du dispositif électronique. Le microcontrôleur 28 comporte également des moyens de conversion 29 de la valeur de Rt en un coefficient de compression du connecteur souple 3. Le coefficient de compression correspond à une variation de dimension de la distance entre les extrémités 7, 8 des lamelles conductrices 4 du connecteur souple 3 lorsque ce dernier 3 est interposé en contact entre l'écran d'affichage 1 et la carte de commande 2. Le microcontrôleur 28 comporte enfin des moyens de comparaison 30 du coefficient de compression calculé par rapport à une valeur de consigne contenue dans des moyens de mémoire 31 associés aux moyens de comparaison 30. Il est estimé que si cette variation est inférieure à 10%, la mise en relation du connecteur souple 3 avec l'écran d'affichage 1 et la carte de commande 2 est susceptible d'être défectueuse.

Selon une alternative non représentée, il est prévu de réaliser le connecteur souple 3 avec une seule lamelle conductrice supplémentaire 21 et de relier la piste additionnelle 26 à une des sorties de l'écran d'affichage qui est par exemple du type à cristaux liquide « LCD ». Lors du contrôle de l'état de compression, le circuit de pilotage de l'écran d'affichage 1 est mis en haute impédance. La piste 26 est ensuite polarisée en pont diviseur comme expliqué ci-dessus pour contrôler l'état de compression du connecteur souple 3.

## Revendications

1. Dispositif électronique comprenant au moins deux composants électroniques (1, 2) reliés électriquement l'un à l'autre par 5 l'intermédiaire d'un connecteur souple (3) comportant une pluralité de lamelles conductrices (4) le connecteur souple (3) étant interposé entre les deux composants électroniques (1, 2) de telle sorte que des bords longitudinaux (11) du connecteur souple (3) soient maintenues en contact contre des plots respectifs de connexion (16, 17) que comporte chacun des composants électroniques (1, 2) et finalement comprimés, respectivement contre l'un (1) et l'autre (2) composants électroniques, et le dispositif électronique étant équipé d'un moyen de contrôle (32) de l'état de compression du connecteur souple (3), **caractérisé en ce que** le moyen de contrôle (32) comprend un circuit électrique (23) pour la détermination de l'état de compression du connecteur souple (3) par une mesure résistive et intégrant au moins une lamelle conductrice supplémentaire (21) du connecteur souple (3).

2. Dispositif électronique selon la revendication 1, **caractérisé en ce que** le connecteur souple comprend une succession alternée de lamelles électriquement conductrices (4) et de lamelles électriquement isolantes (5), orientées parallèlement aux bords latéraux (6) du connecteur souple (3) de sorte que les extrémités (7, 8) d'une lamelle conductrice (4) et les extrémités (9, 10) d'une lamelle isolante (5) soient disposées en alternance aux bords longitudinaux (11) du connecteur souple 3.

3. Dispositif électronique selon la revendication 2, **caractérisé en ce que** les lamelles électriquement conductrices (4) sont réalisées en carbone.

4. Dispositif électronique selon la revendication 2 ou 3, **caractérisé en ce que** les lamelles électriquement isolantes (5) sont réalisées en une matière plastique souple, notamment de la silicone.

5. Dispositif électronique selon l'une quelconque des revendications 1 à 4, dans lequel le circuit électrique (23) intègre deux lamelles conductrices supplémentaires (21) du connecteur souple (3) qui sont respectivement disposées aux bords latéraux opposés (6) de ce dernier (3).

6. Dispositif électronique selon l'une quelconque des revendications 1 à 5, dans lequel le circuit électrique (23) comprend une résistance de référence Rf montée en série avec au moins une lamelle conductrice supplémentaire (21).

7. Dispositif électronique selon l'une quelconque des revendications précédentes, dans lequel le moyen de contrôle (32) comprend en outre des moyens de calcul (27) de la résistance totale Rt du circuit électrique (23).

8. Dispositif électronique selon la revendication 7, dans lequel le moyen de contrôle (32) comprend des moyens de conversion (29) de la résistance totale mesurée Rt du circuit électrique (23) en un coefficient de compression du connecteur souple (3).

9. Dispositif électronique selon la revendication 8, dans lequel le moyen de contrôle (32) comprend des moyens de comparaison (30) du coefficient de compression calculé par rapport à une valeur de consigne.

10. Dispositif électronique selon la revendication 9, dans lequel la valeur de consigne est de 10%.

11. Dispositif électronique selon l'une quelconque des revendications précédentes, dans lequel un premier composant électronique (1) est un écran d'affichage tandis qu'un deuxième composant électronique (2) est une carte de commande de la mise en oeuvre de l'écran d'affichage.

12. Dispositif électronique selon la revendication 11, dans lequel l'écran d'affichage est un écran à cristaux liquides.

13. Dispositif électronique selon la revendication 12, dans lequel une partie du circuit électrique (23) est porté par l'écran d'affichage.

14. Dispositif électronique selon l'une quelconque des revendications précédentes, dans lequel le moyen de contrôle (32) est logé à l'intérieur du dispositif électronique.

15. Tableau de commande comprenant un dispositif électronique selon l'une des revendications précédentes.

16. Appareil apte à coopérer avec le moyen de contrôle (32) du dispositif électronique selon l'un des revendications 1 à 6 pour déterminer l'état de compression du connecteur souple (3), comprenant des moyens de calcul (27) de la résistance totale Rt du circuit électrique (23), des moyens de conversion (29) de la résistance totale mesurée Rt du circuit électrique (23) en un coefficient de compression du connecteur souple (3) et des moyens de comparaison (30) du coefficient de compression calculé par rapport à une valeur de consigne.

17. Appareil selon la revendication 16, dans lequel la valeur de consigne est de 10%.

**Claims**

1. Electronic device comprising at least two electronic components (1, 2) linked electrically to one another by way of a flexible connector (3) comprising a plurality of conducting blades (4), the flexible connector (3) being interposed between the two electronic components (1, 2) in such a way that longitudinal edges (11) of the flexible connector (3) are held in contact against respective connection pads (16, 17) that each of the electronic components (1, 2) comprises and ultimately compressed, respectively, against one (1) and the other (2) electronic component, and the electronic device being equipped with a means (32) for checking the state of compression of the flexible connector (3), **characterized in that** the checking means (32) comprises an electrical circuit (23) for determining the state of compression of the flexible connector (3) by a resistive measurement and integrating at least one additional conducting blade (21) of the flexible connector (3).

2. Electronic device according to Claim 1, **characterized in that** the flexible connector comprises an alternating succession of electrically conducting blades (4) and of electrically insulating blades (5), oriented parallel to the lateral edges (6) of the flexible connector (3) so that the ends (7, 8) of a conducting blade (4) and the ends (9, 10) of an insulating blade (5) are arranged alternately at the longitudinal edges (11) of the flexible connector (3).

3. Electronic device according to Claim 2, **characterized in that** the electrically conducting blades (4) are made of carbon.

4. Electronic device according to Claim 2 or 3, **characterized in that** the electrically insulating blades (5) are made of a flexible plastic, in particular of silicone.

5. Electronic device according to any one of Claims 1 to 4, in which the electrical circuit (23) integrates two additional conducting blades (21) of the flexible connector (3) which are respectively arranged at the opposite lateral edges (6) of the latter (3).

6. Electronic device according to any one of Claims 1 to 5, in which the electrical circuit (23) comprises a reference resistor Rf mounted in series with at least one additional conducting blade (21).

7. Electronic device according to any one of the preceding claims, in which the checking means (32) furthermore comprises means (27) for calculating the total resistance Rt of the electrical circuit (23).

8. Electronic device according to Claim 7, in which the checking means (32) comprises means (29) for converting the measured total resistance Rt of the electrical circuit (23) into a coefficient of compression of the flexible connector (3).

9. Electronic device according to Claim 8, in which the checking means (32) comprises means (30) for comparing the compression coefficient calculated with respect to a preset value.

10. Electronic device according to Claim 9, in which the preset value is 10%.

11. Electronic device according to any one of the preceding claims, in which a first electronic component (1) is a display screen while a second electronic component (2) is a control card for driving the operation of the display screen.

12. Electronic device according to Claim 11, in which the display screen is a liquid crystal screen.

13. Electronic device according to Claim 12, in which a part of the electrical circuit (23) is carried by the display screen.

14. Electronic device according to any one of the preceding claims, in which the checking means (32) is housed inside the electronic device.

15. Control board comprising an electronic device according to one of the preceding claims.

16. Apparatus able to cooperate with the checking means (32) of the electronic device according to one of Claims 1 to 6 so as to determine the state of compression of the flexible connector (3), comprising means (27) for calculating the total resistance Rt of the electrical circuit (23), means (29) for converting the measured total resistance Rt of the electrical circuit (23) into a coefficient of compression of the flexible connector (3) and means (30) for comparing the compression coefficient calculated with respect to a preset value.

17. Apparatus according to Claim 16, in which the preset value is 10%.

**Patentansprüche**

1. Elektronische Vorrichtung, die mindestens zwei elektronische Bauteile (1, 2) enthält, die über einen biegsamen Verbinder (3) elektrisch miteinander verbunden sind, der eine Vielzahl von leitenden Lamellen (4) aufweist, wobei der biegsame Verbinder (3) so zwischen die zwei elektronischen Bauteile (1, 2) eingefügt ist, dass Längsränder (11) des biegsamen Verbinders (3) gegen jeweilige Anschlusskontakte (16, 17), die jedes der elektronischen Bauteile (1, 2) aufweist, in Kontakt gehalten und schließlich gegen das eine (1) bzw. das andere (2) elektronische Bauteil komprimiert werden, und die elektronische Vorrichtung mit einer Überwachungseinrichtung (32) des Kompressionszustands des biegsamen Verbinders (3) ausgestattet ist, **dadurch gekennzeichnet, dass** die Überwachungseinrichtung (32) eine elektrische Schaltung (23) zur Bestimmung des Kompressionszustands des biegsamen Verbinders (3) durch eine Widerstandsmessung und mindestens eine zusätzliche leitende Lamelle (21) des biegsamen Verbinders (3) umfassend enthält.

2. Elektronische Vorrichtung nach Anspruch 1, **dadurch gekennzeichnet, dass** der biegsame Verbinder eine abwechselnde Folge von elektrisch leitenden Lamellen (4) und elektrisch isolierenden Lamellen (5) enthält, die parallel zu den Seitenrändern (6) des biegsamen Verbinders (3) ausgerichtet sind, so dass die Enden (7, 8) einer leitenden Lamelle (4) und die Enden (9, 10) einer isolierenden Lamelle (5) abwechselnd an den Längsrändern (11) des biegsamen Verbinders (3) angeordnet sind.

3. Elektronische Vorrichtung nach Anspruch 2, **dadurch gekennzeichnet, dass** die elektrisch leitenden Lamellen (4) aus Kohlenstoff hergestellt sind.

4. Elektronische Vorrichtung nach Anspruch 2 oder 3, **dadurch gekennzeichnet, dass** die elektrisch isolierenden Lamellen (5) aus einem biegsamen Kunststoff bestehen, insbesondere aus Silikon.

5. Elektronische Vorrichtung nach einem der Ansprüche 1 bis 4, bei der die elektrische Schaltung (23) zwei zusätzliche leitende Lamellen (21) des biegsamen Verbinders (3) umfasst, die je an den entgegengesetzten Seitenrändern (6) dieses letzteren (3) angeordnet sind.

6. Elektronische Vorrichtung nach einem der Ansprüche 1 bis 5, bei der die elektrische Schaltung (23) einen Bezugswiderstand Rf enthält, der mit mindestens einer zusätzlichen leitenden Lamelle (21) in Reihe geschaltet ist.

7. Elektronische Vorrichtung nach einem der vorhergehenden Ansprüche, bei der die Überwachungseinrichtung (32) außerdem Einrichtungen (27) zur Berechnung des Gesamtwiderstands Rt der elektrischen Schaltung (23) enthält.

8. Elektronische Vorrichtung nach Anspruch 7, bei der die Überwachungseinrichtung (32) Einrichtungen (29) zur Umwandlung des gemessenen Gesamtwiderstands Rt der elektrischen Schaltung (23) in einen Kompressionskoeffizienten des biegsamen Verbinders (3) enthält.

9. Elektronische Vorrichtung nach Anspruch 8, bei der die Überwachungseinrichtung (32) Einrichtungen (30) zum Vergleich des Kompressionskoeffizienten mit einem Sollwert enthält.

10. Elektronische Vorrichtung nach Anspruch 9, bei der der Sollwert 10% beträgt.

11. Elektronische Vorrichtung nach einem der vorhergehenden Ansprüche, bei der ein erstes elektronisches Bauteil (1) ein Anzeigebildschirm ist, während ein zweites elektronisches Bauteil (2) eine Steuerkarte der Anwendung des Anzeigebildschirms ist.

12. Elektronische Vorrichtung nach Anspruch 11, bei der der Anzeigebildschirm ein Flüssigkristallbildschirm ist.

13. Elektronische Vorrichtung nach Anspruch 12, bei der ein Teil der elektrischen Schaltung (23) vom Anzeigebildschirm getragen wird.

14. Elektronische Vorrichtung nach einem der vorhergehenden Ansprüche, bei der die Überwachungseinrichtung (32) im Inneren der elektronischen Vorrichtung untergebracht ist.

15. Schalttafel, die eine elektronische Vorrichtung nach einem der vorhergehenden Ansprüche enthält.

16. Gerät, das mit der Überwachungseinrichtung (32) der elektronischen Vorrichtung nach einem der Ansprüche 1 bis 6 zusammenwirken kann, um den Kompressionszustand des biegsamen Verbinders (3) zu bestimmen, das Einrichtungen (27) zur Berechnung des Gesamtwiderstands Rt der elektrischen Schaltung (23), Einrichtungen (29) zur Umwandlung des gemessenen Gesamtwiderstands Rt der elektrischen Schaltung (23) in einen Kompressionskoeffizienten des biegsamen Verbinders (3) und Einrichtungen (30) zum Vergleich des berechneten Kompressionskoeffizienten mit einem Sollwert enthält.

17. Gerät nach Anspruch 16, bei dem der Sollwert 10% beträgt.

Fig.1

Fig.2

Fig. 3

Fig.4

Fig.5

Fig.7

Fig.6

EP 2 153 497 B1

Fig.8

**EP 2 153 497 B1**

## RÉFÉRENCES CITÉES DANS LA DESCRIPTION

**Documents brevets cités dans la description**

- EP 1322001 A